Europäisches Patentamt

European Patent Office

Office européen des brevets

(11) Veröffentlichungsnummer: **0 489 959 A1**

# (12) EUROPÄISCHE PATENTANMELDUNG

(21) Anmeldenummer: **90123971.5**

(22) Anmeldetag: **12.12.90**

(51) Int. Cl.5: **H03M 1/50**, G01K 1/02,
G01L 1/22

(43) Veröffentlichungstag der Anmeldung:
**17.06.92 Patentblatt 92/25**

(84) Benannte Vertragsstaaten:
**AT BE CH DE DK ES FR GB GR IT LI LU NL SE**

(71) Anmelder: **Bohn, Dieter**

Otto-Hahn-Strasse 5
W-6703 Limburgerhof(DE)

(72) Erfinder: **Bohn, Dieter**
Otto-Hahn-Strasse 5
W-6703 Limburgerhof(DE)

(54) **Verfahren und Schaltungsanordnung zur Umsetzung der Signale von Brückenschaltungen mit einer aktiven Messimpedanz und wenigstens einer passiven Vergleichsimpedanz in messsignalproportionale Digitalwerte.**

(57) Die Erfindung bezieht sich auf ein Verfahren zur Umsetzung der Meßsignale von Brückenschaltungen in Digitalwerte mittels des in der DE 3814941 beschriebenen PPDM-Wandlers. Dazu wird der PPDM-Wandler mit einem Strom $i_R + i_E$ geladen, der dem Spannungsabfall $U_o + U_m$ über der aktiven Meßimpedanz entspricht, und mit einem Strom $i_C$ entladen, der dem Spannungsabfall $U_o$ über einer passiven Vergleichsimpedanz entspricht. Das Verfahren verknüpft die hohe Umsetzungsgenauigkeit des PPDM-Wandlers mit den Vorteilen einfacher Brückenschaltungen zu einer übergeordneten Umsetzungsfunktion, die sich gegenüber konventionellen Umsetzungsverfahren durch deutlich verringerten Aufwand auszeichnet.

EP 0 489 959 A1

Zur Analog/Digital-Wandlung von Meßsignalen bestehen eine Vielzahl von Verfahren. In der betrieblichen Meßpraxis hat sich insbesondere der integrierende Analog/Digital-Wandler bewährt, da er hohe Meßgenauigkeit mit hoher Betriebssicherheit verbindet. Dieser Wandler-Typ basiert auf der abwechselnden Ladung eines Kondensators mit dem zu digitalisierenden, von einem analogen Meßwert abhängigen Ladestrom und der Entladung des Kondensators mit einem Referenzstrom.

In der Deutschen Patentschrift DE 3814941 C1 ist ein besonders genaues Verfahren (das PPDM-Verfahren) zur Analog/Digital-Wandlung beschrieben. In diesem Verfahren werden drei verschiedene Ströme zur Ladung und Entladung der Ladekapazität verwendet: ein stetiger Ladestrom $i_E$, dessen Wert in einen proportionalen digitalen Wert umgesetzt werden soll, ein Referenzstrom $i_K$, mit dem während einer Phase $T_1$ zusätzlich geladen wird und ein zweiter Referenzstrom $-i_K$, mit dem während einer zweiten Phase $T_2$ periodisch entladen wird.

In einer Modifikation dieses Verfahrens wird die Ladekapazität stetig mit der Summe der Ströme $i_R$ und $i_E$ geladen und während der Phase $T_2$ mit dem Strom $i_C$ entladen. Zur Analog/Digital-Wandlung von Sensorsignalen, insbesondere der Ausgangssignale von Wheatstone-Brücken werden nach dem Stand der Technik Meßanordnungen eingesetzt, in denen zunächst über einen Differenzverstärker ein zur Brückenauslenkung proportionales Spannungssignal $U_m$ gebildet wird, das als Eingangssignal für den nachfolgenden Analog/Digital-Wandler dient. Bei Verwendung eines PPDM-Wandlers steuert die Spannung $U_m$ den Eingangsstrom $i_E$.

Da die Differenz der Ausgangsspannungen der Wheatstone-Brücke, wie in der Deutschen Offenlegungsschrift DE 3817098 A1 dargelegt, erheblichen parametrischen Einflüßen unterliegt, wurden diverse Kompensationsschaltungen vorgeschlagen um z.B. die Einflüße der Ohm'schen Widerstände der Versorgundsleitungen auf das Meßergebnis zu kompensieren. Ein verbreitetes Verfahren zur Kompensation von auf die Brücke einwirkenden Störgrößen ist die Sechsleitertechnik. Modifizierte Verfahren werden in den "Meßtechnischen Briefen", 12. Jg. (1976), Heft 1, unter dem Beitrag "Eine Vielstellenmeßanlage mit FET-Schaltern. Teil I: Schaltungskonzeption" beschrieben.

Alle bekannten Problemlösungen verursachen erheblichen Aufwand.

Dem erfindungsgemäßen Verfahren liegt demnach die Aufgabe zugrunde, aus den analogen Brückensignalen ein digitales Signal mit deutlich geringerem Aufwand als bei den bisher bekannten Verfahren abzuleiten. Die erfindungsgemäße Lösung nutzt die funktionelle Ähnlichkeit der beiden Brückensignale $U_o$ und $U_o + U_m$ zu den Eingangsströmen $i_C$ und $i_R + i_E$ der modifizierten Schaltung gemäß der DE 3814941 C1 zu einer spezifischen Form der Kopplung von Brücke und PPDM-Wandler und ist dadurch gekennzeichnet, daß die Ladekapazität des PPDM-Wandlers mit einem Strom $i_R + i_E$ geladen wird, der dem Spannungsabfall $U_o + U_m$ über der aktiven Meßimpedanz entspricht und daß die Entladung durch einen Strom $i_C$ erfolgt, der dem Spannungsabfall $U_o$ über einer passiven Vergleichsimpedanz entspricht.

Durch die erfindungsgemäße Form der Brückenkopplung an den PPDM-Wandler wird das Verhältnis zweier Brückensignale in das Verhältnis zweier Zeitintervalle umgesetzt. Die Genauigkeit der Summenfunktion im Bereich zwischen Brücke und Digitalwert erhöht sich, wird in weiten Grenzen unabhängig vom Wert der effektiven Brückenspeisespannung, und Maßnahmen zur Kompensation von Leitungswiderständen werden überflüßig. Maximale Umsetzungsgenauigkeit wird demnach bei Standardbeschaltung (Vierleitertechnik) der Brücke erreicht. Weitere positive Wirkungen auf die Meßgenauigkeit werden mittels des erfindungsgemäßen Verfahrens dadurch erzielt, daß Störgrößen wie die Betriebstemperatur der Brücke, Alterungsdriften, Einstreuungen von elektromagnetischen Störimpulsen über die Verhältnisbildung weitgehend kompensiert werden.

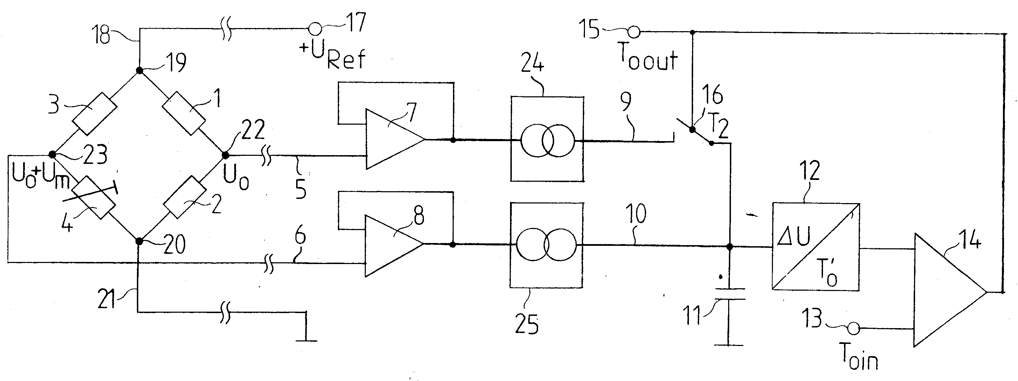

Die Zeichnung zeigt beispielhaft eine Schaltungsanordnung entsprechend dem erfindungsgemäßen Verfahren als Modifizierung und Erweiterung der Fig. 1 in der DE 3814941 C1. Die Brücke aus den vier Impedanzen 1, 2, 3, 4 wird in der Schaltungsanordnung gemäß Zeichnung aus einer Spannungsquelle 17 ($+U_{Ref}$) über eine Zuleitung 18 und den Eingang 19 versorgt. Der negative Eingang 20 ist im Beispiel über Leitung 21 auf Bezugspotential gelegt.

Bei einer Meßanordnung, die nur eine Halbbrücke mit einer passiven Impedanz 3 und einer aktiven Impedanz 4 enthält, wird die Kopplung wie folgt vorgenommen: als Referenzsignal dient die über der passiven Impedanz 3 abfallende Spannung zwischen dem Eingang 19 und dem Ausgang 20. Sie wird beispielsweise über einen Differenzverstärker erfaßt, der den Spannung/Strom-Wandler 24 und damit den Entladestrom $i_C$ für die Ladekapazität 11 des PPDM-Wandlers steuert. Entsprechend wird der Ladestrom $i_R + i_E$ aus einem Spannung/Strom-Wandler 25 durch eine Spannung gesteuert, die der über der aktiven Impedanz 4 zwischen Ausgang 23 und Eingang 20 abfallenden Spannung proportional ist. Diese kann ebenfalls mittels eines Differenzverstärkers erfaßt werden.

Der PPDM-Wandler besteht im wesentlichen aus der Ladekapazität 11, dem Konverter 12 für die Regelabweichung $\Delta U/T_o$, einem Phasenkomparator 14 für den Phasenvergleich des am Eingang 13

anstehenden Pulses $T_{oin}$ mit dem internen Signal $T_o'$, der das Ergebnissignal $T_{oout}$ liefert, das an Ausgang 15 ansteht und als Rückkopplungssignal für die Regelschaltung den Schalter 16 steuert.

Für die Vollbrücke (Wheatstone-Brücke) ergibt sich das folgende Kopplungsschema an den PPDM-Wandler: der Ausgang 22 der Halbbrücke aus den beiden passiven Impedanzen 1 und 2 führt die Spannung $U_o$, die als Referenzsignal zur Steuerung des Entladestroms $i_C$ während der Phase $T_2$ dient. Dazu wird die Spannung $U_o$ über eine Leitung 5 an den Eingang eines Impedanzwandlers 7 geführt, dessen Ausgang den Spannung/Strom-Wandler 24 steuert, der der PPDM-Schaltung über eine Leitung 9 und den Schalter 16 einen der Spannung $U_o$ proportionalen Entladestrom $i_C$ einprägt. Die Spannung $U_o + U_m$ an Ausgang 23 der zweiten Brückenhälfte mit einer passiven Impedanz 3 und einer aktiven Impedanz 4 steuert den stetigen Ladestrom $i_R + i_E$. Dazu wird die Spannung $U_o + U_m$ über eine Leitung 6 zu einem zweiten Impedanzwandler 8 geführt, der den zweiten Spannung/Strom-Wandler 25 steuert und der PPDM-Schaltung über eine Leitung 10 einen der Spannung $U_o + U_m$ proportionalen Ladestrom $i_R + i_E$ einprägt.

Ein besonderer Vorteil gegenüber konventionellen Auswerteschaltungen ergibt sich aus dem erfindungsgemäßen Verfahren dadurch, daß hohe Verstärkungsfaktoren für die Differenzverstärker nicht erforderlich sind und in typischen Applikationen der Verstärkungsfaktor im Bereich $v = 1$ liegt.

Da sich ein Differenzverstärker mit dem Verstärkungsfaktor $v = 2$ aus technologischen Gründen besonders einfach darstellen läßt, werden in einer erfindungsgemäßen Schaltungsanordnung vorzugsweise Differenzverstärker mit dem Nennverstärkungsfaktor 2 eingesetzt.

## Patentansprüche

1. Verfahren zur Umsetzung der Signale von Brückenschaltungen mit einer aktiven Meßimpedanz (4) und wenigstens einer passiven Vergleichsimpedanz (3) in meßsignalproportionale Digitalwerte, dadurch kennzeichnet, daß die Ladekapazität (11) eines PPDM-Wandlers mit einem Strom $i_R + i_E$ geladen wird, der dem Spannungsabfall $U_o + U_m$ über der aktiven Meßimpedanz (4) einer Halbbrücke entspricht, und daß die Entladung durch einen Strom $i_C$ erfolgt, der dem Spannungsabfall $U_o$ über einer passiven Vergleichsimpedanz (3) der Halbbrücke entspricht.

2. Verfahren nach Anspruch 1, dadurch gekennzeichnet, daß die Spannung $U_o + U_m$ des Signalausgangs (23) einer Wheatstone-Halbbrück-ke aus einer passiven Impedanz (3) und einer aktiven Impedanz (4) einen zu $U_o + U_m$ proportionalen Ladestrom $i_R + i_E$ in die Ladekapazität (11) eines PPDM-Wandlers steuert, und daß die Spannung $U_o$ des Vergleichsausgangs (22) der Wheatstone-Halbbrücke aus zwei passiven Impedanzen (1, 2) einen zu $U_o$ proportionalen Entladestrom $i_C$ in die Ladekapazität (11) steuert.

3. Schaltungsanordnung nach Anspruch 1, dadurch gekennzeichnet, daß die Spannungsabfälle über der aktiven und der passiven Impedanz einer Halbbrücke mittels Differenzverstärkern erfaßt werden, daß der Differenzverstärker mit der zum Spannungsabfall $U_o + U_m$ über der aktiven Impedanz (4) proportionalen Ausgangsspannung einen Spannung/Strom-Wandler (25) steuert, der den zu $U_o + U_m$ proportionalen Ladestrom $i_R + i_E$ in die PPDM-Schaltung einprägt, und daß der Differenzverstärker mit dem zum Spannungsabfall $U_o$ über der passiven Impedanz (3) proportionalen Ausgangsspannung einen Spannung/Strom-Wandler (24) steuert, der den zu $U_o$ proportionalen Entladestrom in die PPDM-Schaltung steuert.

4. Schaltungsanordnung nach Anspruch 2, dadurch gekennzeichnet, daß dem Signal-Ausgang (23) einer Wheatstone-Brücke, welche die Spannung $U_o + U_m$ führt, ein Impedanzwandler (8) nachgeschaltet ist, der den Spannung/Strom-Wandler (25) steuert, welcher der PPDM-Schaltung einen der Spannung $U_o + U_m$ proportionalen Ladestrom $i_R + i_E$ einprägt, und daß dem Vergleichsausgang (22) der Wheatstone-Brücke, welcher die Spannung $U_o$ führt, ein Impedanzwandler (7) nachgeschaltet ist, der den Spannung/Strom-Wandler (24) steuert, welcher der PPDM-Schaltung den der Spannung $U_o$ proportionalen Entladestrom $i_C$ einprägt.

EP 0 489 959 A1

18

17
+U_Ref

19

3

1

22

23

$U_0+U_m$

$U_0$

4

2

5

20

6

21

7

8

24

25

9

10

15
$T_{oout}$

16
$T_2$

11

12
$\Delta U$ / $T_0'$

13
$T_{oin}$

14

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | EP-A-0 173 833 (BAUMANN) 12. März 1986<br>* Seite 3, Zeile 18 - Seite 7, Zeile 12; Abbildungen 3-4 * | 1 | H03M1/50<br>G01K1/02<br>G01L1/22 |
| A | | 3-4 | |
| A | DE-A-2 356 837 (HAYASHI  EIJI MACHIDA) 22. Mai 1974<br>* Seite 3, Zeile 3 - Seite 6; Abbildungen 1-2 * | 1-4 | |
| A | DE-A-3 041 954 (ABUTORAB) 13. Mai 1982<br>* Seite 8, Zeile 1 - Seite 8, Zeile 10 * | 1 | |
| D,A | DE-A-3 814 941 (BOHN) 4. Januar 1990<br>* das ganze Dokument * | 1 | |

**RECHERCHIERTE SACHGEBIETE (Int. Cl.5 )**

H03M
G01K
G01L

Der vorliegende Recherchenbericht wurde für alle Patentansprüche erstellt

| Recherchenort | Abschlußdatum der Recherche | Prüfer |
|---|---|---|
| DEN HAAG | 23 JULI 1991 | GUIVOL Y. |

EPO FORM 1503 03.82 (P0403)